# EUROPÄISCHE PATENTSCHRIFT

(11) **EP 1 563 553 B1**
(45) Veröffentlichungstag und Bekanntmachung des Hinweises auf die Patenterteilung: **14.02.2007**
(21) Anmeldenummer: 03785505.3
(22) Anmeldetag: 13.11.2003
(51) Int. Cl.: H01L 51/50

(54) **ORGANISCHE ELEKTRONISCHE SCHALTUNG MIT STUKTURIERTER HALBLEITENDER FUNKTIONSSCHICHT UND HERSTELLUNGSVERFAHREN DAZU**
ORGANIC ELECTRONIC CIRCUITCOMPRISING A STRUCTURED, SEMI-CONDUCTIVE FUNCTIONAL LAYER AND A METHOD FOR PRODUCING SAID COMPONENT
CIRCUIT ELECTRONIQUE ORGANIQUE COMPORTANT UNE COUCHE FONCTIONNELLE SEMICONDUCTRICE STRUCTUREE ET PROCEDE DE FABRICATION DE CE COMPOSANT

(30) Priorität: 19.11.2002 DE 10253953
(43) Veröffentlichungstag der Anmeldung: 17.08.2005
(73) Patentinhaber: PolyIC GmbH & Co. KG, 90763 Fürth (DE)
(72) Erfinder: CLEMENS, Wolfgang, 90617 Puschendorf (DE); FIX, Walter, 90427 Nürnberg (DE); ULLMANN, Andreas, 90765 Fürth (DE)
(74) Vertreter: Zinsinger, Norbert
(86) Internationale Anmeldenummer: PCT/DE2003/003770
(87) Internationale Veröffentlichungsnummer: WO 2004/047144

(56) Entgegenhaltungen:
- WO-A-99/54936
- DE-A- 19 918 193
- US-A1- 2003 059 987

## Beschreibung

Die Erfindung betrifft ein organisches elektronisches Bauelement wie einen organischen Feld-Effekt-Transistor und ein Herstellungsverfahren dazu, wobei die halbleitende Schicht des Bauelements strukturiert ist.

Bei organischen elektronischen Bauelementen werden die organischen halbleitenden Funktionsschichten üblicherweise großflächig durch Spin-coating, Aufsprühen, Rakeln oder ähnliches als homogene großflächige aber sehr dünne Funktionsschichten aufgebracht. Siehe z.B. WO9954936.

Bei einer integrierten Schaltung kann das zu Problemen führen, da Leckströme von einem Bauelement oder von einer Elektrode zur nächsten entstehen, wenn die halbleitenden Funktionsschichten der Bauelemente aneinander stoßen. Diese Leckströme stören die Performance der Schaltung zum Teil erheblich. Deshalb werden Versuche unternommen, die halbleitenden Funktionsschichten zu strukturieren und/oder sie auf die aktiven Flächen, also die Bereiche wo sich Stromkanäle ausbilden, zu reduzieren. Diese Strukturierung kann bei photolithographisch hergestellten Bauelementen durch entsprechende Belichtungsmasken erreicht werden. Für eine breite Anwendung werden aber photolithographisch hergestellte Bauelemente zu teuer. Deshalb wird bei der Entwicklung der Elemente auf preisgünstige Druckherstellungsmethoden fokussiert.

Die halbleitende Funktionsschicht kann jedoch nicht durch herkömmliche Druckmethoden strukturiert aufgebracht werden, weil diese Schicht sehr dünn sein muss (typischerweise kleiner 100nm), damit sie funktioniert. Die beispielsweise für die halbleitende Funktionsschicht geforderten Schichtdicken sind herkömmlicherweise nur über Belackung wie Coating, Aufsprühen etc. zu erreichen.

Aufgabe der vorliegenden Erfindung ist es, bei gedruckt hergestellten organischen elektronischen Bauelementen eine Strukturierung einer dünnen, insbesondere der halbleitenden Funktionsschicht zu ermöglichen, ohne dass dabei die Schichtdicke der betroffenen Funktionsschicht gegenüber einer normalerweise durch Belackung (Coating, Aufsprühen, Einrakeln) hergestellten, z.B. halbleitenden, Funktionsschicht gesteigert wird.

Gegenstand der Erfindung ist ein organisches elektronisches Bauelement mit einer strukturierten halbleitenden Funktionsschicht einer Dicke kleiner 100nm, wobei die Strukturierung dadurch entsteht, dass eine untere Funktionsschicht nur partiell mit dem organischen Funktionsmaterial der nächsten Funktionsschicht benetzt wird. Außerdem ist Gegenstand der Erfindung ein Verfahren zur Herstellung eines organischen elektronischen Bauelements, bei dem durch gezielte Behandlung einer unteren Funktionsschicht eine obere Funktionsschicht trotz großflächiger Auftragung strukturiert erzeugt wird.

Nach einer Ausführungsform des Verfahrens wird eine halbleitende Schicht strukturiert erzeugt.

Nach einem Ausführungsbeispiel wird die untere Funktionsschicht durch einen Lack partiell abgedeckt, der durch Drucken in ganz geringer Schichtdicke aufbringbar ist.

Als obere, strukturierte Funktionsschichten können durch das Verfahren halbleitende, isolierende, und/oder leitende organische Funktionsschichten, aber natürlich auch anorganische Funktionsschichten, wie z.B. dünne Metallschichten strukturiert hergestellt werden.

Die untere Funktionsschicht ist je nach Aufbau des organischen elektronischen Bauelements und der oberen Schicht das Substrat, eine leitende Funktionsschicht etc.

Als "gezielte Behandlung" wird die partielle Abdeckung und/oder die lokale Veränderung der unteren Funktionsschicht bezeichnet, die bewirkt, dass in ausgewählten Bereichen der unteren Funktionsschicht beim Belacken mit dem Material Benetzung stattfindet oder vermieden wird (also "partielle Benetzung" stattfindet), kann mittels einer Druckmethode, durch Laserbehandlung, Wärmebehandlung, andere physikalische, elektrische oder chemische Behandlung, immer jedoch partiell und mit einer Auflösung im µm-Bereich, erfolgen. Beispielhaft genannt sei die partielle Kontaktierung mit Säure/Base oder anderen reaktiven chemischen Substanzen, physikalische Effekte wie Licht, Wärme, Kälte und schließlich die mechanische Behandlung wie Reiben. Die Folge der Behandlung ist in jedem Falle die, dass die nächste Funktionsschicht auf den behandelten Stellen nicht oder nur dort benetzt.

Der Begriff "organisches Material" und/oder "Funktionspolymer" umfasst hier alle Arten von organischen, metallorganischen und/oder anorganischen Kunststoffen, die im Englischen z.B. mit "plastics" bezeichnet werden. Es handelt sich um alle Arten von Stoffen mit Ausnahme der Halbleiter, die die klassischen Dioden bilden (Germanium, Silizium), und der typischen metallischen Leiter. Eine Beschränkung im dogmatischen Sinn auf organisches Material als Kohlenstoff enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich.

Im folgenden wird die Erfindung noch anhand zweier Figuren, die eine Draufsicht und einen Querschnitt durch ein Ausführungsbeispiel eines erfindungsgemäßen organischen elektronischen Bauteils zeigen:

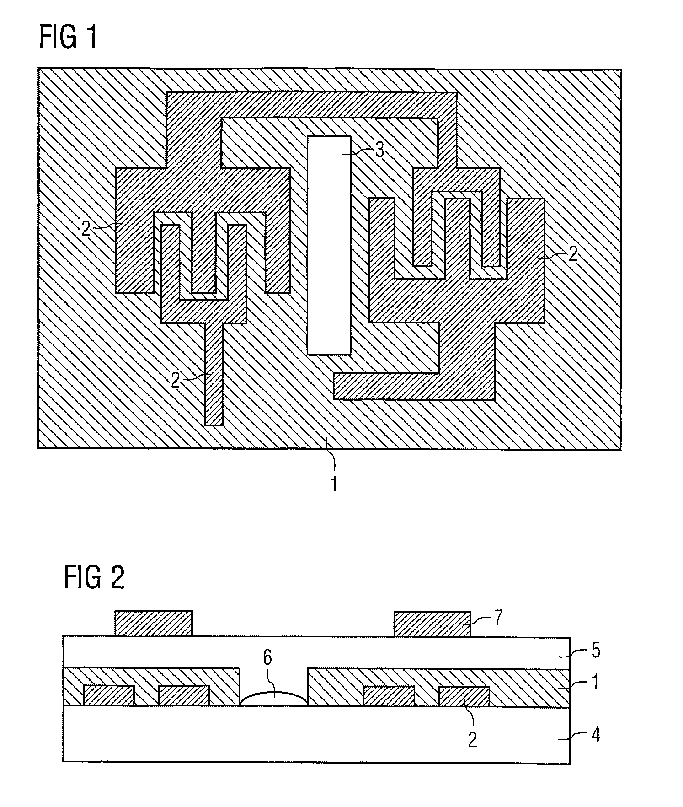

Figur 1 zeigt eine Aufsicht auf eine Schaltung mit einer strukturierten halbleitenden Funktionsschicht. Zu sehen ist eine organische Schaltung, die auf einem Substrat (verdeckt) aufgebaut ist. Es sind mehrere aktive Elemente wie organische Feld-Effekt-Transistoren nebeneinander angeordnet, zu erkennen sind jeweils die Source/Drain Elektroden 2. Der schraffierte Bereich zeigt die organische Halbleiterschicht 1, die strukturiert ist und Teilbereiche 3 hat, die frei von halbleitendem Funktionsmaterial sind. Durch den freien Bereich 3 ("frei" heißt hier weder mit leitendem noch mit halbleitendem Material bedeckt) wird ein Leckstrom vom linken in den rechten Bereich der Schaltung unterdrückt.
Figur 2 zeigt einen OFET mit dem Substrat 4 und den Source/Drain Elektroden 2. Auf der leitenden Funktionsschicht, den Source/Drain Elektroden 2 befindet sich die strukturierte halbleitende Funktionsschicht 1, die sich nicht ganzflächig über die leitende Funktionsschicht 2 erstreckt, sondern die durch den Lack 6, der das Substrat 4 partiell gegen die Benetzung mit halbleitender Funktionsschicht 1 abdeckt, unterbrochen, also strukturiert nur die aktiven Flächen, das heißt die Flächen oberhalb der Source/Drain Elektroden, bedeckt. Die halbleitende Funktionsschicht ihrerseits wird durch die isolierende Funktionsschicht 5 bedeckt, auf der sich die Gate-Elektroden 7 befinden.

Die Erfindung betrifft ein organisches elektronisches Bauelement wie einen organischen Feld-Effekt-Transistor und ein Herstellungsverfahren dazu, wobei eine dünne Schicht, wie die halbleitende Schicht des Bauelements strukturiert ist, obwohl das Bauelement im preisgünstigen Druckverfahren herstellbar ist. Um dies zu erreichen wird die untere Funktionsschicht durch eine Behandlung so präpariert, dass sie Teilbereiche hat, auf denen im nachfolgenden Prozessschritt Benetzung stattfindet und Teilbereiche, auf denen keine Benetzung erfolgt.

## Patentansprüche

1. Organische Schaltung mit mehreren, nebeneinander angeordneten organischen elektronischen Bauelementen, wobei die Bauelemente eine gemeinsame gedruckte strukturierte organische halbleitende Funktionsschicht einer Dicke kleiner 100nm aufweisen, wobei die Strukturierung der gemeinsamen Funktionsschicht **dadurch** gebildet ist, dass eine angrenzend und unterhalb der gemeinsamen Funktionsschicht angeordnete untere Funktionsschicht nur partiell mit einem zur Bildung der gemeinsamen Funktionsschicht verwendeten organischen Funktionsmaterial benetzt ist und wobei die gemeinsame Funktionsschicht in nicht benetzten Bereichen der unteren Funktionsschicht unterbrochen ist, wobei die Unterbrechung derart zwischen den Bauelementen angeordnet sind, dass ein Leckstrom zwischen den benachbarten Bauelementen unterdrückt ist.

2. Verfahren zur Herstellung einer organischen Schaltung nach Anspruch 1,
**dadurch gekennzeichnet,**
**dass** zur Herstellung der organischen elektronischen Bauelemente eine gezielte Behandlung der unteren Funktionsschicht erfolgt, so dass die untere Funktionsschicht nur partiell mit dem zur Bildung der gemeinsamen Funktionsschicht verwendeten organischen Funktionsmaterial benetzbar ist, dass das organische Funktionsmaterial zur Bildung einer oberen Funktionsschicht auf der unteren Funktionsschicht großflächig aufgetragen wird, wobei eine obere Funktionsschicht gebildet wird, die trotz großflächiger Auftragung strukturiert erzeugt wird und welche die strukturierte organische Funktionsschicht ausbildet.

3. Verfahren nach Anspruch 2,
**dadurch gekennzeichnet,**
**dass** die gezielte Behandlung der unteren Funktionsschicht durch ein partielles Belacken der unteren Funktionsschicht mittels Drucken erfolgt.

4. Verfahren nach einem der Ansprüche 2 oder 3,
**dadurch gekennzeichnet,**
**dass** die gezielte Behandlung der unteren Funktionsschicht durch eine partielle physikalische, elektrische oder chemische Behandlung, insbesondere durch eine Laserbehandlung, Wärmebehandlung, Kältebehandlung, Säure/Basebehandlung, Lichtbehandlung oder Reibbehandlung erfolgt.

## Claims

1. Organic circuit comprising a plurality of organic electronic components arranged alongside one another, the components having a common printed patterned organic semiconducting functional layer having a thickness of less than 100nm, the patterning of the common functional layer being formed by virtue of a lower functional layer, which is arranged in a manner adjoining and below the common functional layer, being only partially wetted with an organic functional material used for forming the common functional layer, and the common functional layer being interrupted in non-wetted regions of the lower functional layer, the interruption being arranged between the components in such a way as to suppress a leakage current between the adjacent components.

2. Method for producing an organic circuit according to Claim 1,
**characterized**
**in that**, for the production of the organic electronic components, a targeted treatment of the lower functional layer is effected, so that the lower functional layer can be only partially wetted with the organic functional material used for forming the common functional layer, in that the organic functional material, for the formation of an upper functional layer, is applied on the lower functional layer in large-area fashion, an upper functional layer being formed which is produced in patterned fashion despite large-area application and which forms the patterned organic functional layer.

3. Method according to Claim 2,
**characterized**
**in that** the targeted treatment of the lower functional layer is effected by means of a partial coating of the lower functional layer by means of printing.

4. Method according to either of Claims 2 and 3,
**characterized**
**in that** the targeted treatment of the lower functional layer is effected by means of a partial physical, electrical or chemical treatment, in particular by means of a laser treatment, thermal treatment, cold treatment, acid/base treatment, light treatment or rubbing treatment.

## Revendications

1. Circuit organique comportant plusieurs composants électroniques organiques juxtaposés, lesdits composants comportant une couche fonctionnelle organique commune semi-conductrice, imprimée, structurée avec une épaisseur inférieure à 100 nm, la structuration de la couche fonctionnelle commune étant formée par le fait qu'une couche fonctionnelle inférieure, agencée de manière adjacente et en dessous de la couche fonctionnelle commune, est humectée seulement partiellement par un matériau fonctionnel organique utilisé pour former la couche fonctionnelle commune, et la couche fonctionnelle commune étant interrompue dans des zones non humectées de la couche fonctionnelle inférieure, l'interruption étant disposée entre les composants, de telle sorte qu'un courant de fuite entre les composants adjacents est empêché.

2. Procédé de réalisation d'un circuit organique selon la revendication 1, **caractérisé en ce que**, pour la réalisation des composants électroniques organiques, la couche fonctionnelle inférieure est soumise à un traitement ciblé, de telle sorte que la couche fonctionnelle inférieure ne peut être humectée que partiellement avec le matériau fonctionnel organique utilisé pour la formation de la couche fonctionnelle commune, **en ce que**, pour former une couche fonctionnelle supérieure, le matériau fonctionnel organique est appliqué sur une grande surface sur la couche fonctionnelle inférieure, moyennant quoi une couche fonctionnelle supérieure est formée, laquelle est structurée malgré l'application sur une grande surface et laquelle forme la couche fonctionnelle organique structurée.

3. Procédé selon la revendication 2, **caractérisé en ce que** le traitement ciblé de la couche fonctionnelle inférieure est effectué par un vernissage partiel de la couche fonctionnelle inférieure au moyen d'une impression.

4. Procédé selon la revendication 2 ou 3, **caractérisé en ce que** le traitement ciblé de la couche fonctionnelle inférieure est effectué par un traitement partiel physique, électrique ou chimique, en particulier un traitement laser, un traitement thermique, un traitement à froid, un traitement à base d'acide, un traitement par lumière ou un traitement par frottement.
